# EUROPEAN PATENT APPLICATION

(11) **EP 2 221 830 A1**
(43) Date of publication of application: **25.08.2010**
(21) Application number: 10152169.8
(22) Date of filing: 29.01.2010
(51) Int. Cl.: G11C 16/34, G11C 29/00

(54) **Memory device and wear leveling method thereof**

(30) Priority: 10.02.2009 KR 20090010775
(71) Applicant: Samsung Electronics Co., Ltd., Suwon-si Gyeonggi-do 443-742 (KR)
(72) Inventor: Hwang, Joo-young, Gyeonggi-do (KR); Lee, Jamee Kim, Seoul (KR); Kim, Hong-kug, Gyeonggi-do (KR)
(74) Representative: D'Halleweyn, Nele Veerle Trees Gertrudis

(57) **Abstract**

Disclosed is a memory device including a N VRAM and a page table, and a wear leveling method therefor. The page table includes mapping information which maps virtual addresses of the NVRAM with physical addresses of the NVRAM. A page table entry includes aging information which indicates the wear of a corresponding page. The aging information may be a remaining number of write operations allowed to the page. Whenever data is written in a page, a value indicating a remaining number of write operations allowed to that page is decremented.

## Description

The present invention relates to a memory device and a wear leveling method thereof.

A non-volatile random access memory (NVRAM) is a RAM, in which data stored thereon is not lost when power is turned off. NVRAM may be used to store files or execute processes. Since information stored in a NVRAM is not lost when power is turned off, the system can be restored quickly to its original condition in the case where power is abruptly turned off. When a user arbitrarily turns off power or when power failure occurs, a NVRAM conveniently allows restoration of data. Examples of NVRAM include a phase change RAM (PRAM), a ferroelectric RAM (FeRAM), a magnetic RAM (MRAM), and the like.

In addition, because a NVRAM typically has lower power consumption in comparison to a dynamic random access memory (DRAM), when a DRAM is replaced by a NVRAM, system power consumption may be significantly reduced. Additionally, a NVRAM does not require a memory to erase previously stored memory before writing new memory to a specified location. Accordingly, a NVRAM supports overwriting previously stored data with the new data. However, when compared to a DRAM, for example, NVRAM can only provide a limited number of writing operations.

With respect to this problem, an improved NVRAM is provided by the device of independent claim 1 and the method of independent claim 13.

According to one aspect, a memory device includes a memory including a non-volatile random access memory (NVRAM), and a controller to control the memory, wherein the controller manages a page table including mapping information that maps virtual addresses of the NVRAM to physical addresses of the NVRAM, and an entry of the page table includes aging information indicating the wear of a corresponding page of the NVRAM.

The aging information may indicate a remaining number of write operations allowed to the corresponding page, and whenever data is written on the corresponding page, the controller decrements by 1 the remaining number of write operations allowed to that page.

The memory device may further include a non-volatile memory that is controlled by the controller, wherein the controller stores aging information of each page in the non-volatile memory when power is off, restores a remaining number of write operations for each page stored in the non-volatile memory upon booting, and performs memory allocation on the memory based on the aging information of each page.

The controller may register and manage a black list including information of one or more worn pages which are pages that are not to be used, store the black list in the non-volatile memory when power is off, and restore the black list stored in the non-volatile memory upon booting.

If a write operation is performed on a page where the number of write operations already performed on the page equals or exceeds a threshold value, the controller may generate a page fault, copy content of the page to a free page, and modify the page table corresponding to the page so that a virtual address of the page is mapped to a physical address of the free page.

If a write operation is performed on a page where the number of write operations performed on the page equals or exceeds a threshold value, the controller may generate a page fault and prevents memory allocation from being performed on the page.

The controller may perform memory allocation according to a buddy allocation algorithm based on a binary tree data structure, and if a page fault occurs at a node on the binary tree data structure during memory allocation, the controller may mark the node and at least one upper node of the node, and if page allocation is requested based on a size of at least one node and successive spaces have to be allocated, the controller may prevent pages corresponding to the marked nodes from being allocated.

The page table may include a layer-1 page table which manages physical addresses corresponding to virtual addresses in units of super sections that are larger than units of pages, and a layer-2 page table which manages physical addresses corresponding to virtual addresses in units of pages, wherein the layer-1 page table may include information about a remaining number of write operations allowed to each supersection, and the layer-2 page table may include information about a remaining number of write operations allowed to each page.

The page table may include a layer-2 page table that maps virtual addresses with physical addresses in units of pages, and a layer-1 page table that indicates a location of the layer-2 page table, wherein the layer-2 page table includes information about a remaining number of write operations allowed to each page.

The entry of the page table may include identifier information indicating whether the page table includes pointer information indicating a location of a memory at which the aging information is stored.

If a page is shared by two or more processes, the entry of the page table may include pointer information indicating a location of a memory storing aging information of the shared page, and if a page is used only by one process, the entry of the page table may include aging information of the page used by one process.

When a page shared by two or more processes ceases to be shared, aging information corresponding to that page stored in a memory may be copied to an aging field of that page and if a page which was previously not shared becomes shared by two or more processes, a value of an aging field of that page may be copied to a location of a memory, and pointer information indicating the location may be stored in the aging field of that page.

According to another aspect, a method is provided for wear leveling of a memory device, the memory device comprising a memory including a non-volatile random access memory (NVRAM) and a controller to control the memory, wherein a page table corresponding to the NVRAM includes mapping information which maps virtual addresses of the NVRAM with physical addresses of the NVRAM, and an entry of the page table includes aging information which indicates the wear of a corresponding page, the method including writing data on a page; and decrementing a remaining number of write operations by one in response to the writing on the page, the remaining number of write operations being indicated in aging information provided in an entry of the page table corresponding to the page.

When the number of write operations performed on the page exceeds a threshold value, the method may further include generating a page fault, copying content of the page to a free page, and modifying the page table so that a virtual address of the page is mapped to a physical address of the free page.

The method may further include performing memory allocation based on the aging information, wherein the performing of the memory allocation comprises generating a page fault if a write operation is performed on the page where the number of write operations allowed on the page has reached a threshold value, and preventing the page from being allocated.

Other features and aspects will be apparent from the following detailed description and the claims, with reference to the drawings, wherein
FIG. 1 is a block diagram illustrating an exemplary memory device;
FIG. 2 illustrates a structure of an exemplary page table;
FIG. 3A illustrates an exemplary aging field when a page is not shared, and FIG. 3B illustrates an exemplary aging field when a page is shared by a plurality of processes.;
FIG. 4 is a flowchart illustrating an exemplary wear leveling method for a memory device; and
FIG. 5 is a flowchart illustrating an exemplary method of processing a page fault generated upon memory allocation.

Throughout the drawings and the detailed description, unless otherwise described, the same drawing reference numerals will be understood to refer to the same elements, features, and structures. The relative size and depiction of these elements may be exaggerated for clarity, illustration, and convenience.

The following detailed description is provided to assist the reader in gaining a comprehensive understanding of the methods, apparatuses and/or systems described herein. Accordingly, various changes, modifications, and equivalents of the systems, apparatuses, and/or methods described herein will be suggested to those of ordinary skill in the art. Also, descriptions of well-known functions and constructions may be omitted for increased clarity and conciseness.

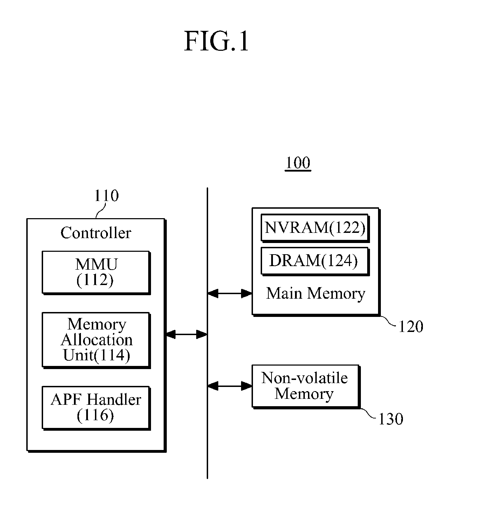

FIG. 1 illustrates an exemplary memory device 100.

The memory device 100 includes a controller 110, a main memory 120, and a non-volatile memory 130. The straight line in FIG. 1 represents a system bus through which data and instructions may be transferred.

The controller 110 may be a CPU or microcontroller.

The main memory 120 is a memory which can exchange data directly with the controller 110, and may be used by the controller 110 when an operating system (OS) or application is executed. The main memory 120 includes, for example, a non-volatile random access memory (NVRAM) 122 and a dynamic random access memory (DRAM) 124.

The controller 110 stores data that is to be used by the OS, in the DRAM 124. Page tables and data used for memory allocation of the NVRAM 122 may be used by the OS and they may be stored in the DRAM 124. The data used for memory allocation of the NVRAM 122 may include, for example, a binary tree. The binary tree may be used and accessed when, for example, a buddy allocation algorithm is performed.

A process for a general user application may request memory allocation to the OS after specifying whether the process requests memory allocation to the DRAM 124 or to the NVRAM 122.

Data stored in the non-volatile memory 130 is not lost when power is turned off. Data stored in the non-volatile memory 130 is loaded in the main memory 110 and then processed by the controller 110. Examples of the non-volatile memory 130 include a flash memory, a hard disk, and the like.

The controller 110 includes a memory management unit (MMU) 112, a memory allocation unit 114, and an aging page fault (APF) handler 116. The controller 110 may further include one or more other functional unit, and the functions of the MMU 112, memory allocation unit 114, and APF handler 116 may be performed by the one or more other functional units. In other words, the controller 110 may be implemented in various ways.

The MMU 112 converts virtual addresses of a memory area referred to by the controller 110 into physical addresses. For example, the MMU 112 converts virtual addresses into physical addresses by referring to a page table indicating which physical memory page is mapped to which virtual memory page.

According to an aspect, a page table entry includes aging information indicating the wear of a page. The page table entry may include aging information, or pointer information indicating a location of a memory at which the aging information is stored. Age may be managed in a unit of page. All bytes on a page have the same age.

A page table entry may include an aging field including aging information. The aging information of the page table entry may indicate a remaining number of write operations allowed on the page before the page reaches an endurance limit.

The MMU 112 manages aging information of a memory area in association with the writing performed on the memory area. Whenever data is written on a certain page, the MMU 112 updates aging information included in a page table entry of the page by decrementing a value of the aging information, for example, decrementing the value by one.

An initial value of an aging field is set when the corresponding page table entry is initialized. The initial value of the aging field may be set to value α which may be the endurance limit of the NVRAM 122. The α value is a constant which is set by the OS, for example, and is used to prevent a write operation from being performed on worn pages which have reached the endurance limit. A page table entry of each page includes a value for a remaining number of write operations α. The controller decrements the α value by 1 whenever data is written on the page Keeping track of the α value allows the memory device to know when the α value becomes or nears zero.

As an example, the MMU 112 does not update aging information included in an aging field of a page whenever a storage instruction is executed, but decrements a value of the aging information by 1 when a write operation is actually performed on a corresponding memory. That is, even if the controller 110 executes a storage instruction, and if data is cached on a CPU cache, updating of aging information does not occur. The storage instruction may be performed in units of bytes, words, multiple-words, and the like.

The controller 110 stores aging information of each page in the non-volatile memory 130 when power is off, restores a remaining number of write operations for each page stored in the non-volatile memory 130 upon booting, and performs memory allocation on the main memory 120 based on the aging information of each page. The controller 110 may generate and manage a black list including information about worn pages whose value for remaining write operations α is at, for example, zero. Worn pages are no longer used because no remaining write operations are allowed to be performed on that page. The controller 110 may store the black list in the non-volatile memory 130 when power is off, and restore the black list stored in the non-volatile memory 130 upon booting.

The memory allocation unit 114 performs memory allocation used to execute computer programs. The memory allocation unit 114 may allocate memory to the NVRAM 122 according to, for example, a buddy allocation algorithm.

When a write operation is performed on a page whose remaining number of write operations α equals or exceeds a threshold value, the controller 110 generates an aging page fault (APF) for the page and prevents the page from being used. The MMU 112 allows the APF handler 116 to perform fault processing on a page whose remaining number of write operations is zero. For example, the MMU 112 decrements a value of aging information of a page by 1 whenever data is written in the page, and generates an aging page fault when the value of the aging information reaches zero.

When an aging page fault is generated, the APF handler 116 performs fault processing on the page in which the aging page fault has been generated. The APF handler 116 may be included in the OS. The APF handler 116 copies the content of the page in which the page fault has been generated, and transfers the content to a free page. The MMU 112 may modify the corresponding page table so that a virtual address originally mapped to the physical address of the full page is now mapped to the physical address of the free page.

In an exemplary embodiment, the controller performs memory allocation according to a buddy allocation algorithm based on a binary tree data structure, and if a page fault occurs at a node on the binary tree data structure during memory allocation, the controller marks the node and at least one upper node of the node. The performing of the memory allocation may include performing memory allocation according to a buddy algorithm that performs page allocation based on a binary tree data structure, and if a page fault is generated at a node on the binary tree data structure when the memory allocation is performed, the method may further include marking the node and at least one upper node of the node, and determining whether page allocation based on a size of the at least one upper node is requested and whether allocation of successive spaces is requested, wherein if the page allocation based on the size of the at least one upper node is requested and the allocation of successive spaces is requested, pages corresponding to the marked nodes are excluded from the memory allocation.

Provided herein is an exemplary method in which the memory allocation unit 114 allocates memory according to a buddy allocation algorithm.

The buddy allocation algorithm splits and manages a memory area into sections each having 2ⁿ pages. The buddy allocation algorithm searches for a requested block size of memory by splitting the whole memory into two equal blocks and determines if the split block size of memory is the suitable size for the requested block size of memory. If the split block size is not the suitable size of memory, the algorithm splits the blocks again. This is repeated until the size of the split blocks is the suitable size for the requested block size of memory. The split blocks are merged into one block after allocating memory to the searched block is completed. The buddy allocation algorithm may perform page allocation based on a binary tree data structure or a hash table data structure. Herein, two equal blocks that are to be merged after memory allocation is released may be considered to be a buddy to each other.

As an illustration, buddy allocation algorithm based on the binary tree data structure is provided below. In the binary tree data structure, each node of a tree corresponds to 2ⁿ pages. If a predetermined parent node corresponds to 2^{k} pages, a child node of the parent node corresponds to **2**^{k-1} pages. Therefore, a child node is half the size of a parent node. Also, a buddy refers to a node corresponding to a sibling on a tree of the buddy system.

Each node includes information about the node. The node information may include the number of pages included in the node, identifier information of a corresponding buddy node, the number of pages in which page faults occur in the pages included in the node, identifier information of child nodes of the node, identifier information of a parent node of the corresponding node, and information indicating the occurrence of page splitting on the node.

When memory allocation is performed, information about whether pages have to be arranged on physically successive spaces is received. There is the case where successive space allocation is required, such as memory allocation for interfacing with an external device. In this case, memory allocation may fail if successive memory spaces are not prepared.

In the case of allocating 2^{k} pages, a free node among the nodes each having 2^{k} pages is searched for. If a free node comprising 2^{k} pages is found, memory allocation is performed on the free node. Because the block of memory needed is of a size of pages somewhere between 2^{k} and 2^{k-1} + 1 pages, if there is no node having 2^{k} pages, nodes having a smaller size of 2^{k-1} pages would likely fail during memory allocation because there is not enough pages in the node. Therefore, if a node having 2^{k} pages is not found, a node having a size larger than 2^{k} pages, for example, 2^{k+1} pages is searched for, and if found, pages corresponding to the searched node are split and subjected to memory allocation.

An endurance limit of the DRAM 124 may be initialized to a maximum value (for example, 2³⁰-1) which may be represented by the aging information, and initialization of the endurance limit may occur whenever booting up.

If page faults occur in the NVRAM 122 while the memory allocation unit 114 performs memory allocation, the APF handler 116 marks all nodes on a binary tree, including pages in which the page faults occur. That is, nodes in which the page faults occur and upper nodes or ancestors of the nodes, located on the binary tree, are all marked. The marking operation may be implemented by incrementing by one the number of pages in which page faults occur, which may be included in the node information.

The memory allocation unit 114 prevents the pages in which the page faults occur, from being allocated. If successive memory spaces corresponding to a certain size have to be allocated, the memory allocation unit 114 may prevent marked nodes from being allocated. If successive memory spaces do not need to be allocated, the lower nodes of the marked nodes are searched for and the unmarked lower nodes may be used for memory allocation.

The method may further include storing aging information of each page in a non-volatile memory when power is off, restoring a remaining number of write operations for each page stored in the non-volatile memory upon booting, and performing memory allocation based on the restored remaining number of write operations.

The method may further include registering a worn page whose remaining number of write operations has reached a threshold value, in a black list, and managing the black list.

The black list stored in the non-volatile memory 130, may be read when the OS boots up. The reading may be performed by the memory allocation unit 114. For example, the memory allocation unit 114 may mark pages registered in the black list and binary nodes corresponding to ancestors of the pages, in the same manner as marking all nodes on a binary tree, including pages in which page faults occur. Then, the marked nodes are not used when memory allocation is performed on successive spaces.

As described above, according to an exemplary embodiment, a page table of the NVRAM 122 may include aging information indicating the wear of each page, and aging information of each page may be updated whenever data is written on that page. This may be used to prevent the occurrence of bad pages and system crash when the NVRAM 122 is used as a main memory.

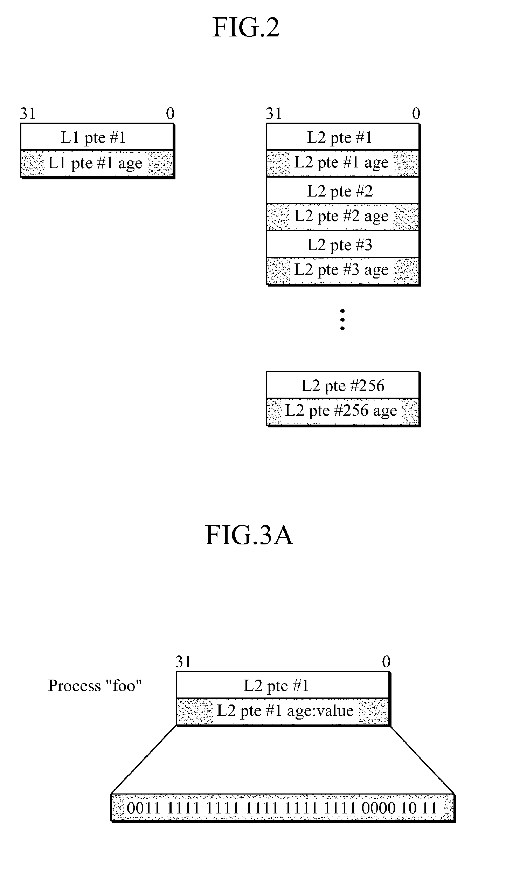

FIG. 2 illustrates a structure of an exemplary page table.

The page table may have a hierarchical structure, for example, one layer, two layers, three layers, or more. The ARMv6 CPU includes a layer-1 page table called a page directory and a layer-2 page table called a coarse page table.

In FIG. 2, an entry of the layer-1 page table is denoted by *LI pte*, and an entry of the layer-2 page table is denoted by *L2 pte.* For example, the entry of the layer-1 page table may include management information for a section with a size of 1MB and a super section with a size of 16MB. The entry of the layer-1 page table may include information about the location of the layer-2 page table, and the entry of the layer-2 page table may include management information for each of the pages included in the layer-1 page table.

In a conventional 32-bit processor in which one pte is 32 bits, an aging field needs a minimum of 26 bits when a NVRAM having an endurance limit of 10⁷ is provided.

According to an aspect, each page table entry may be extended to 64 bits by adding 32 bits of an aging field without having to modify the configurations of existing *L1 pte* and *L2 pte.* In this case, since 32 bits of an aging field are added to each of the *L1 pte* and the *L2 pte*, the size of a page table is doubled compared to a conventional method.

For example, a page table structure may include a layer-1 page table which manages physical addresses corresponding to virtual addresses in a unit of a supersection. The supersection is larger than a page unit. The layer-2 page table manages physical addresses corresponding to virtual addresses, in units of pages. In this case, aging information *L1 pte #1 age* of the entry of the layer-1 page table may include a remaining number of write operations allowed to each supersection. All pages belonging to a supersection may have the same aging information. Aging information (for example, *L2 pte #1 age*) of the entry of the layer-2 page table, may include a remaining number of write operations allowed to the corresponding page *L2 pte #1.*

The page table structure may include a layer-2 page table which includes information of physical addresses that correspond to virtual addresses in unit of pages. The layer-1 page table indicates a location of the entry of the layer-2 page table. In this case, the entry of the layer-2 page table may include a remaining number of write operations in units of pages.

By storing a value indicating the lifetime of the NVRAM to a page table entry for the NVRAM and decrementing the value whenever data is written on pages of the NVRAM, more efficient management on the wear of the NVRAM may be possible when the NVRAM is used as a main memory to which more write operations are required to be allowed.

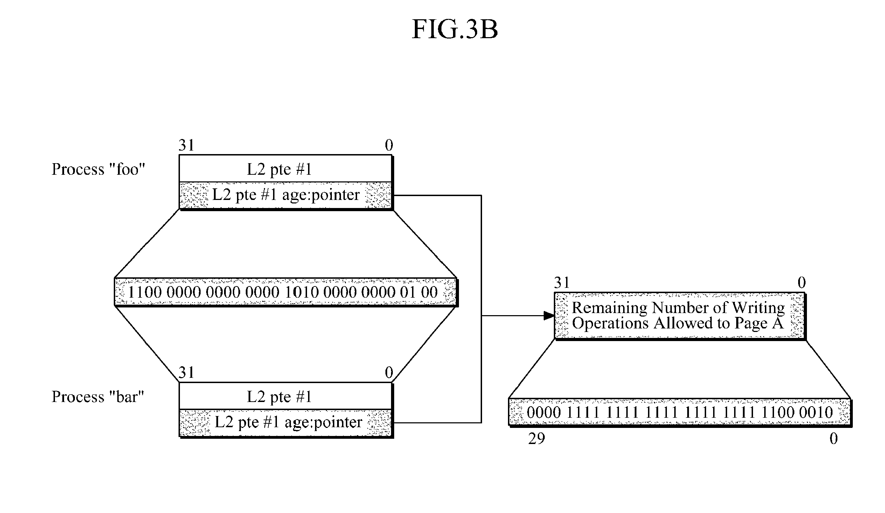

FIG. 3A illustrates an exemplary aging field when a page is not shared, and FIG. 3B illustrates an exemplary aging field when a page is shared by a plurality of processes.

The page table may include identifier information indicating whether the entry of the page table includes pointer information indicating a location of a memory at which the aging information is stored, or whether the entry of the page table includes the aging information.

If the page is shared by two or more processes, the entry of the page table may include the pointer information indicating the location of the memory storing the aging information of the shared page, and if the page is used by one process, the entry of the page table may include the aging information of the page.

FIG. 3A shows a page table entry of a page A when the page A is used only by a process "foo". In FIG. 3A, aging information *L2 pte #1 age* included in the page table entry represents a remaining number of write operations allowed to page A. When aging information is allocated 32 bits, some bits may be allocated to identifier information which indicates the aging information's own value. In FIG. 3A, the lowest 2 bits "11" represent identifier information which indicates the aging information's own value.

FIG. 3B shows a page entry of a page A where the page A is shared by two processes "foo" and "bar". When a page is shared by two or more processes, a remaining number of write operations allowed to the page is not stored in the corresponding page table entry but is stored in another location in memory. In this case, aging information of the page does not indicate a remaining number of write operations allowed to the page but includes pointer information indicating an address of a memory in which the remaining number of write operations is stored.

In FIG. 3B, bits "00" are used as identifier information. The identifier information represents that the aging information of the page table entry is a pointer indicating a location of memory which stores an actual remaining number of write operations of the corresponding page A. The aging information *L2 pte #1 age* of a page table entry which is used by the processes "foo" and "bar" is pointer information indicating a memory which stores an actual remaining number of write operations of page A.

The page table entry may include identifier information that indicates the values included in the page table entry. The identifier information is used to distinguish whether the page table entry includes pointer information indicating a location of another memory at which the aging information is stored, or whether the aging information is stored on the current page. The type of the identifier information, as illustrated in FIGS. 3A and 3B, may be represented by a value of the lower 2 bits of the aging field. A value of the lower 2 bits of the aging field indicates whether the upper 30 bits of the aging field is pointer information indicating a memory storing a remaining number of write operations or whether the upper 30 bits comprise the remaining number of write operations. For example, if the value of the lower two bits is 00b, this may be used to indicated that the remaining number of write operations is stored on the page, or that the remaining number of write operations is stored at another location of memory.

If a page is shared by two or more processes, aging information of the page may comprise pointer information indicating another memory which stores the aging information, and if a page is shared by one process, aging information of the page may be the aging information itself.

If a page shared by two or more processes is no longer shared, the MMU 112 of the controller 110 may find aging information stored in another memory indicated by pointer information, and copy the information into an aging field of the page table entry of the page. In an embodiment of the method of the invention, if a page that was not being shared becomes shared by two or more processes, the MMU 112 may copy a value of an aging field of the page into a predetermined location of another memory. The MMU112 may write pointer information indicating the copied location in the aging field of the page.

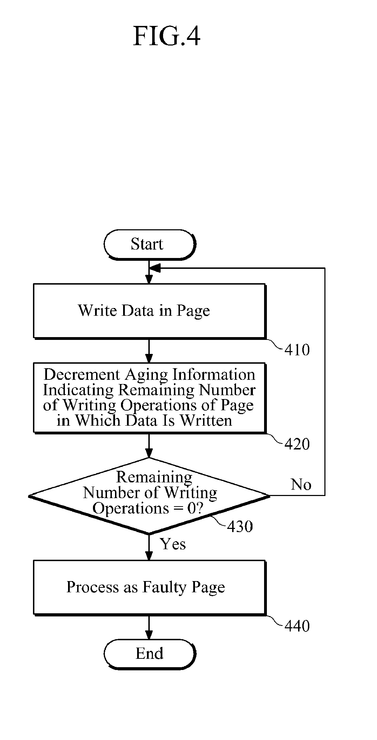

FIG. 4 illustrates an exemplary wear leveling method of a memory device.

In the memory device, a page table may include mapping information which maps virtual addresses of a NVRAM with physical addresses of the NVRAM. The page table may store information about the wear of each page. The memory device may be the memory device 100 of FIG. 1.

In operation 410, data is written in a predetermined page by memory allocation. In operation 420, a remaining number of write operations stored in an aging field of the page is decremented by 1. In operation 430, it is determined if the remaining number of write operations is zero. If the remaining number of operations is not zero, more data can be written to the page.

If in operation 430 it is determined that the remaining number of write operations is zero, the page has reached an endurance limit, and accordingly, the page is considered and processed as a fault page in operation 440. The page that is considered as the fault page is managed so that data is no longer written thereto.

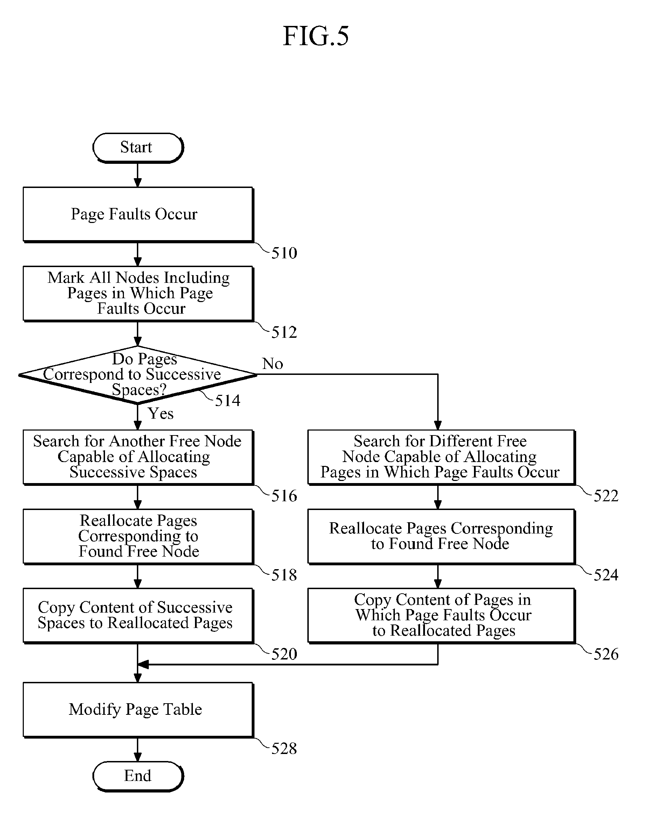

FIG. 5 is a flowchart illustrating an exemplary method of processing a page fault that is generated upon memory allocation. The method may be performed by, for example, the memory device 100 of FIG. 1.

In operation 510, it is determined that a page fault has occurred, and in operation 512, the APF handler 116 marks all nodes in which the page faults occur, for example, ancestor nodes on a binary tree.

In operation 514, a determination is made as to whether pages in the page faults correspond to pages which are needed to allocate successive spaces.

If in operation 514 the pages correspond to pages of successive spaces, the APF handler 116 searches for another free node which can allocate successive spaces in operation 516, and reallocates pages of the searched for and found free node in operation 518. Nodes including any of the pages in which the aging page faults occur are excluded from memory allocation. The pages in which the aging page faults occur and nodes including the pages are all marked, and the marked nodes are skipped when a free node is searched for, so that a page having page faults is not selected.

In operation 520, the content stored in the successive spaces is copied to the reallocated pages. After content of fault pages is copied into the reallocated pages and page reallocation is performed, the MMU 112 modifies a corresponding page table to indicate the reallocated pages in operation 528.

If in operation 514 the pages do not correspond to pages needed to allocate successive spaces, the APF handler 116 searches for another free node in operation 522, and found free pages are reallocated in operation 524. In operation 526, the content of the fault pages is copied into the free page corresponding to the found node. After the content of the fault pages is copied into the free page and page reallocation is performed, the MMU 112 modifies a corresponding page table to indicate the reallocated pages in operation 528.

According to example(s) described above, a wear compensating method for a non-volatile random access memory (NVRAM) is provided. Because NVRAM may provide a limited number of write operations, for example, compared to a DRAM, a wear leveling may be used to avoid memory failure and extend the working life of the NVRAM.

The methods described above may be recorded, stored, or fixed in one or more computer-readable storage media that includes program instructions to be implemented by a computer to cause a processor to execute or perform the program instructions. The media may also include, alone or in combination with the program instructions, data files, data structures, and the like. Examples of computer-readable media include magnetic media, such as hard disks, floppy disks, and magnetic tape; optical media such as CD ROM disks and DVDs; magneto-optical media, such as optical disks; and hardware devices that are specially configured to store and perform program instructions, such as read-only memory (ROM), random access memory (RAM), flash memory, and the like. Examples of program instructions include machine code, such as produced by a compiler, and files containing higher level code that may be executed by the computer using an interpreter. The described hardware devices may be configured to act as one or more software modules in order to perform the operations and methods described above, or vice versa. In addition, a computer-readable storage medium may be distributed among computer systems connected through a network and computer-readable codes or program instructions may be stored and executed in a decentralized manner.

A memory device may comprise flash memory devices and/or memory controllers. For example, the flash memory devices and/or memory controllers may be embodied using packages such as Package on Packages (PoPs), Ball Grid Arrays (BGAs), Chip Scale Packages (CSPs), Plastic Leaded Chip Carrier (PLCC), Plastic Dual In-Line Package (PDIP), Die in Waffle Pack, Die in Wafer Form, Chip On Board (COB), Ceramic Dual In-Line Package (CERDIP), Plastic Metric Quad Flat Pack (MQFP), Quad Flatpack (QFP), Small Outline Integrated Circuit (SOIC), Shrink Small Outline Package (SSOP), Thin Small Outline (TSOP), Thin Quad Flatpack (TQFP), System In Package (SIP), Multi Chip Package (MCP), Wafer-level Fabricated Package (WFP), Wafer-Level Processed Stack Package (WSP), and the like.

The flash memory devices and/or the memory controllers may constitute memory cards. In this case, the memory controllers may be constructed to communicate with an external device for example, a host using any one of various types of interface protocols such as a Universal Serial Bus (USB), a Multi Media Card (MMC), a Peripheral Component Interconnect-Express (PCI-E), Serial Advanced Technology Attachment (SATA), Parallel ATA (PATA), Small Computer System Interface (SCSI), Enhanced Small Device Interface (ESDI), and Integrated Drive Electronics (IDE).

A number of exemplary embodiments have been described above. Nevertheless, it will be understood that various modifications may be made. For example, suitable results may be achieved if the described techniques are performed in a different order and/or if components in a described system, architecture, device, or circuit are combined in a different manner and/or replaced or supplemented by other components or their equivalents. Accordingly, other implementations are within the scope of the following claims.

## Claims

1. A memory device (100) comprising:
a memory (120) including a non-volatile random access memory (122) ; and
a controller (110) to control the memory (120),
wherein the controller (110) manages a page table including mapping information that maps virtual addresses of the non-volatile random access memory (122) to physical addresses of the non-volatile random access memory (122), and an entry of the page table includes aging information indicating the wear of a corresponding page of the non-volatile random access memory (122).

2. The memory device (100) of claim 1, wherein the aging information indicates a remaining number of write operations allowed to the corresponding page, and whenever data is written on the corresponding page, the controller (110) decrements by 1 the remaining number of write operations allowed to that page.

3. The memory device (100) of claim 1 or claim 2, further comprising a non-volatile memory (130) that is controlled by the controller (110),
wherein the controller (110) stores aging information of each page in the non-volatile memory (130) when power is off, restores a remaining number of write operations for each page stored in the non-volatile memory (130) upon booting, and performs memory allocation on the memory (120) based on the aging information of each page.

4. The memory device (100) of claim 3, wherein the controller (110) registers and manages a black list including information of one or more worn pages which are pages that are not to be used, stores the black list in the non-volatile memory (130) when power is off, and restores the black list stored in the non-volatile memory (130) upon booting.

5. The memory device (100) of any of the preceding claims, wherein if a write operation is performed on a page where the number of write operations already performed on the page equals or exceeds a threshold value, the controller (110) generates a page fault, copies content of the page to a free page, and modifies the page table corresponding to the page so that a virtual address of the page is mapped to a physical address of the free page.

6. The memory device (100) of any of the preceding claims, wherein if a write operation is performed on a page where the number of write operations performed on the page equals or exceeds a threshold value, the controller (110) generates a page fault and prevents memory allocation from being performed on the page.

7. The memory device (100) of claim 6, wherein the controller (110) performs memory allocation according to a buddy allocation algorithm based on a binary tree data structure,
wherein if a page fault occurs at a node on the binary tree data structure during memory allocation, the controller (110) marks the node and at least one upper node of the node, and
wherein if page allocation is requested based on a size of at least one node and successive spaces have to be allocated, the controller (110) prevents pages corresponding to the marked nodes from being allocated.

8. The memory device (100) ofany of the preceding claims, wherein the page table includes a layer-1 page table which manages physical addresses corresponding to virtual addresses in units of super sections that are larger than units of pages, and a layer-2 page table which manages physical addresses corresponding to virtual addresses in units of pages, and
wherein the layer-1 page table includes information about a remaining number of write operations allowed to each supersection, and the layer-2 page table includes information about a remaining number of write operations allowed to each page.

9. The memory device (100) of any of the preceding claims, wherein the page table includes a layer-2 page table that maps virtual addresses with physical addresses in units of pages, and a layer-1 page table that indicates a location of the layer-2 page table, wherein the layer-2 page table includes information about a remaining number of write operations allowed to each page.

10. The memory device (100) of any of the preceding claims, wherein the entry of the page table includes identifier information indicating whether the page table includes pointer information indicating a location of a memory at which the aging information is stored.

11. The memory device (100) of claim 10, wherein if a page is shared by two or more processes, the entry of the page table includes pointer information indicating a location of a memory storing aging information of the shared page, and if a page is used only by one process, the entry of the page table includes aging information of the page used by one process.

12. The memory device (100) of claim 11, wherein when a page shared by two or more processes ceases to be shared, aging information corresponding to that page stored in a memory is copied to an aging field of that page, and
wherein if a page which was previously not shared becomes shared by two or more processes, a value of an aging field of that page is copied to a location of a memory, and pointer information indicating the location is stored in the aging field of that page.

13. A method for wear leveling of a memory device (100), the memory device (100) comprising a memory (120) including a non-volatile random access memory (122)and a controller (110) to control the memory, wherein a page table corresponding to the non-volatile random access memory (122) includes mapping information which maps virtual addresses of the non-volatile random access memory (122) with physical addresses of the non-volatile random access memory (122), and an entry of the page table includes aging information which indicates the wear of a corresponding page, the method comprising:
writing (410) data on a page; and
decrementing (420) a remaining number of write operations by one in response to the writing on the page, the remaining number of write operations being indicated in aging information provided in an entry of the page table corresponding to the page.

14. The method of claim 13, wherein when the number of write operations performed on the page exceeds a threshold value, the method further comprises:
generating (510) a page fault;
copying (520, 526) content of the page to a free page; and
modifying (518, 524) the page table so that a virtual address of the page is mapped to a physical address of the free page.

15. The method of claim 13, further comprising performing (440) memory allocation based on the aging information, wherein the performing of the memory allocation comprises generating a page fault if a write operation is performed on the page where the number of write operations allowed on the page has reached a threshold value, and preventing the page from being allocated.
